(19)

Europäisches
Patentamt
European
Patent Office
Office européen
des brevets

(11) **EP 2 343 533 A2**

(12) **EUROPEAN PATENT APPLICATION**

(43) Date of publication:
**13.07.2011 Bulletin 2011/28**

(51) Int Cl.:
***G01N 21/65*** *(2006.01)*

(21) Application number: **11075006.4**

(22) Date of filing: **12.01.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **12.01.2010 ES 201000031**

(27) Previously filed application:
**12.01.2010 ES 201000031**

(72) Inventors:
 • **Nunez, Emilia Morallon, Prof. Dr.**
  **E-03690 San Vicente del Raspeig (ES)**
 • **Salavagiona, Horacio Javier, Dr.**
  **E-03690 San Vicente del Raspeig (ES)**
 • **Barbero, Cesar Alfredo, Prof. Dr.**
  **Rio Cuarto, Córdoba (AR)**
 • **Acevedo, Diego Fernando, Dr.**
  **Rio Cuarto, Córdoba (AR)**

(74) Representative: **Pfenning, Meinig & Partner GbR
Patent- und Rechtsanwälte
An der Frauenkirche 20
01067 Dresden (DE)**

(71) Applicants:
 • **Universidad De Alicante**
  **03690 Alicante (ES)**
 • **Universidad Nacional de Rio Cuarto**
  **Rio Cuarto, Córdoba (AR)**

(54) **Manufacturing method of metal structures for surface enhanced raman spectroscopy**

(57)    Manufacturing method of metal structures, active in surface enhanced Raman spectroscopy or related spectroscopies, implemented in a system comprising at least one lens, a plurality of mirrors and at least one beam splitter; and wherein said manufacturing method comprises at least the following steps: (i) a first step of splitting a laser beam into sub-beams by using a plurality of mirrors, these sub-beams having an impact on the sample of solid material to ablate or structure; (ii) a second step of depositing a metal layer on the SERS active surface structure of the previous step; (iii) a third step of placing the analyte distributed on the surface of the solid material coated with active metal; and (iv) a fourth step of obtaining the Raman spectrum by a monochromatic light incidence on the molecules immobilized on the surface structure.

Figure 1

**Description**

The present invention relates to a manufacturing method of metal surfaces, structured for use in surface enhanced RAMAN spectroscopy and other related spectroscopies.

The present invention shows the preparation of active surfaces for surface enhanced Raman spectroscopy, and other related spectroscopies, by structuring the surface with direct laser interference patterning (DLIP). It can be applied to different materials (metals, ceramics, polymers, etc.) upon which it will be necessary to carry out a second method of active metal deposit in Raman (Au, Cu, Ag, etc.) by different physical, chemical or electrochemical techniques. These surfaces can be used in various applications such as the protection of the environment through the detection of contaminants, and such as sensors of biological molecules or for the identification of polymers.

STATE OF THE PRIOR ART

The Raman spectroscopy is an analytical technique based on the detection of changes in vibrational states in molecules through the detection of the inelastic scattering of light. The light used covers a wide region of the electromagnetic spectrum from ultraviolet-visible to near infrared (200-3000 nm). The technique is an alternative to infrared (IR) spectroscopy, with several advantages: i) the use of visible light allows working in biological systems and in the presence of water; ii) the resolution of a Raman microscope is in the order of 500 - 3000 nm, higher than those of IR microscopes; and iii) the system uses optical materials (quartz, glass) stable in the environment in contrast to the IR which uses hygroscopic materials.

A disadvantage of the Raman spectroscopy is its low sensitivity due to the weakness of the inelastic scattering phenomenon. One way to solve this problem is to increase the signal using coupling phenomena of vibrational systems with electronic transitions.

One of the most widely used techniques is the Raman spectroscopy with Surface Enhanced Raman Spectroscopy (SERS). The phenomenon involves the absorption of light by the electronic states at metal surfaces (Ag, Au, etc.) and the transfer of energy to the vibrational states of the molecule under study. In order to achieve this effect, light absorption centers must comply by either using metal nanoparticles or metal surfaces with nanometric or micrometric cavities. The usefulness of this technique has led to the development of various surfaces to increase the signal: layers of metal nanoparticles, electrochemically corrugated metals, metals structured during deposit, etc. Many of these methods are difficult to implement in practical applications or suffer from poor reproducibility. Other methods, such as the conventional photolithography of metals, are very costly and complex.

The structured surfaces can be used to increase the signal in related spectroscopies, such as infrared or visible ultraviolet fluorescence. In each case, the maximum absorption of the surface plasmon should have a wavelength in the region of the spectroscopic measurement (e.g. in micrometer range for infrared spectroscopy). Since the absorption depends on the size of the structure, the simplicity of producing nanometric or micrometric structures only by changing the geometry of the DLIP method allows the production of specific surfaces for each spectroscopy. This is an advantage over other techniques that can only produce nanometric or micrometric structures.

The known history brings out the following documents. American patent US6623977 which patented the production of a porous film, with metal particles, by sol-gel techniques for use in SERS. However, when metal nanoparticles are deposited on a surface, the control over their aggregation is limited, thus limiting the reproducibility and spatial repetition.

Patent US640677 patented the production of a rough glass surface, covered with metal islands as a substrate for SERS.

Patent US6149868 includes the use of metal nanoparticles, between which the analyte to be identified by SERS is deposited.

Another patent on record is patent US6989897 which protects the use of porous silicon coated with a metal film, as substrate for SERS. The porous silicon is produced by controlled electrochemical corrosion of crystalline silicon.

This patent may have several limitations - the use of silicon as a substrate, the use of electrochemical techniques that are not applicable to mass production and the conditions of the preparation make it difficult to produce on a massive scale (using hydrofluoric acid.) Patent US7158219 protects the use of metal nanowires to produce a SERS active surface. This patent proposes the creation of silicon and germanium nanowires coated with a semiconductor material. The creation of these nanowires are made by lithographic techniques, which involve a sequence of steps that take a long time and require special conditions such as ultra-clean salts, not to mention the problems of reproducibility of this technique.

Patent WO2009035479 relates to SERS active structures and surface enhanced fluorescence made of metal or semiconductor nanowires. The nanowires are made in a vacuum oven, which makes the technique very expensive.

Patent WO2006027581 describes the use of metal structures with nanometric or micrometric holes for use in SERS and related techniques. The holes are made by a method of assembly of polymer spheres on the surface, followed by electrochemical deposit of a metal. However, the compulsory use of conductive surfaces and the multiple steps to produce the parent can limit the scope of this method for mass production.

EXPLANATION OF THE INVENTION

This invention describes a low-cost method for the production of SERS active surfaces. In addition, it was recently observed that other spectroscopies (e.g. fluorescence) present also an increased signal due to the structured surfaces. The manufacturing method, object of the present invention, can also be used for that purpose.

We propose a method of producing active surfaces for surface enhanced Raman spectroscopy (SERS) by structuring solid surfaces by laser ablation using interference patterns. Each of the surfaces is then covered with a thin layer of a SERS active metal and the molecule under study is placed on it. This method will increase the Raman signal to enable identification of the molecule.

This invention proposes the development of active surfaces for surface enhanced Raman spectroscopy by structuring the surface by laser ablation with interference patterns. These surfaces can be used in various applications such as the detection of environmental contaminants, as sensors for biological molecules, or for identification of polymers.

The laser ablation technique with interference patterns has not been previously used to produce active surfaces to increase the Raman signal. This technique incorporates significant advantages over those listed above such as:

> Periodicity, allowing the creation of periodic structures with a well-defined order in the nano/micrometers range using a single laser pulse.
> Speed, in that it generates periodic structures in areas ranging from mm2 to cm2 in a few seconds.
> Simplicity, since in order to produce SERS active substrates it is not necessary to use special facilities such as ultra-clean environments. Moreover, the method is carried out at room temperature without using vacuum conditions.
> Economy, since the substrates, produced in a fast and simple method, can be marketed at very low costs.

In conclusion, the method described is fast, clean and allows patterning of large areas in short periods of time. This method allows the production of homogeneously structured surfaces which ensures reproducibility, one of the main limitations of the SERS substrates known so far. Another important advantage is the great stability of the substrates produced. In addition, the dimensions of the structures can be modified simply by changing the geometry of the interference pattern, allowing the preparation of families of substrates and the choice of the one with maximum sensitivity for the detection. The sensitivity is the result of the light being efficiently absorbed by the surface plasmons whose maximum absorption depends on the shape of the structures.

Throughout the description and claims the word "comprise" and its variations are not intended to exclude other technical features, additives, components or steps. For those skilled in the art, other objects, advantages and features of the invention will emerge from the description and, in part, from the practice of the invention. The following examples and drawings are provided by way of illustration and are not intended to be limiting of the present invention. Furthermore, the present invention covers all possible combinations of particular and preferred embodiments set forth herein.

BRIEF DESCRIPTION OF THE DRAWINGS

> FIG 1. Shows a diagram of the geometric arrangement of two light beams (iii) and three light beams (iv) to produce line structures (i) or points (ii) on the surface of the material.

> FIG 2. Shows a diagram of the system for laser interference, using: (1) lens (2) beam splitters, (3) mirrors (4) sample. In this example, the beam is split into 3 beams.

> FIG 3. Shows SEM microscopies of polyimide surfaces structured by interference, using 2 beams (A) or 3 beams (B).

> FIG 4. Shows the Raman spectrum of p-tioanilina adsorbed on a structured (solid line) or flat (dotted line) surface.

DETAILED DESCRIPTION OF IMPLEMENTATION METHODS and EXAMPLES

The surface is structured by ablation with the interference pattern created by two or more beams of a coherent high-power laser. In order to create the interference, it is necessary to divide the laser beam into multiple beams which are then superimposed with a specific incidence angle. This overlap of the beams generates an interference pattern.

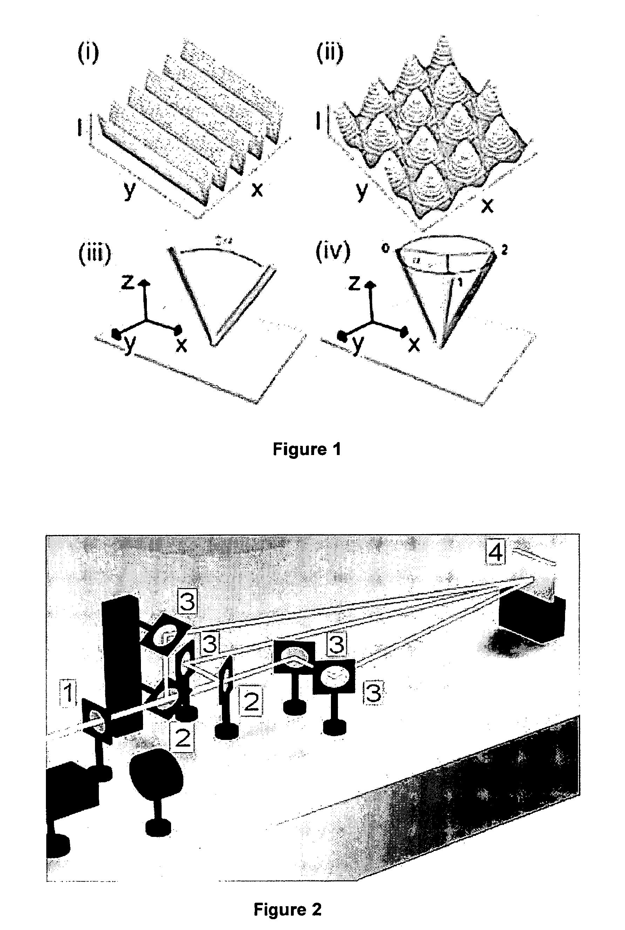

The concept is outlined in Figure 1. As noted, if two beams are used, we obtain a pattern of lines (Figure 1, i and iii) and if three beams with a symmetrical arrangement are used, we obtain an hexagonal array of dots (Figure 1, i and iv). The interference can be achieved by other equivalent devices such as diffraction gratings, lenses, prisms, etc.

Figure 2 describes a type of device using mirrors and a beam splitter. We can see the beam coming out from the laser and passing in the first instance through a focusing lens (1) which determines the focal length where the sample to ablate should be placed (4). Subsequently, the main beam in this example is divided by two beam splitters (2) into three sub-beams, which, through the use of mirrors (3) have an impact on the sample to ablate. The subdivision of beams produces interference onto the sample.

The material to ablate includes one of the following: polymers (e.g. polystyrene, polycarbonate, etc.), metals (e.g. copper, gold, silver), semiconductors (e.g. silicon), oxides (e.g. tin oxide) and ceramics (e.g. silicon nitride). In addition to homogeneous materials, structures can be formed on the monolayer or multilayer materials described above and deposited on an inert substrate.

A pulsed laser is used which has enough energy to cause the ablation of the surface. Fluencies greater than 10 mJ/cm$^2$ are necessary. The wavelength of the light used depends on the material to ablate and on the required resolution, the period of the structure being given by the formula:

$$P = \frac{\lambda}{2\sin\left(\dfrac{\alpha}{2}\right)}$$

where P is the period (distance between two maxima of the structure), A is the wavelength of the laser light and $\alpha$ is the angle between the beams.

Radiation in the ultraviolet region is used for most of the materials because of its absorption and the high resolution obtained. For this purpose, a (1064nm) Nd-YAG laser with 532nm, 355nm and 266nm non-linear crystals is used. Any of these wavelengths can be used to structure the material. In addition, since the material to be structured is not in contact with the molecule under study, materials (e.g. polymers) doped with substances that increase the light absorption (organic dyes and pigments, metal nanoparticles, carbon nanotubes, etc.) can be used.

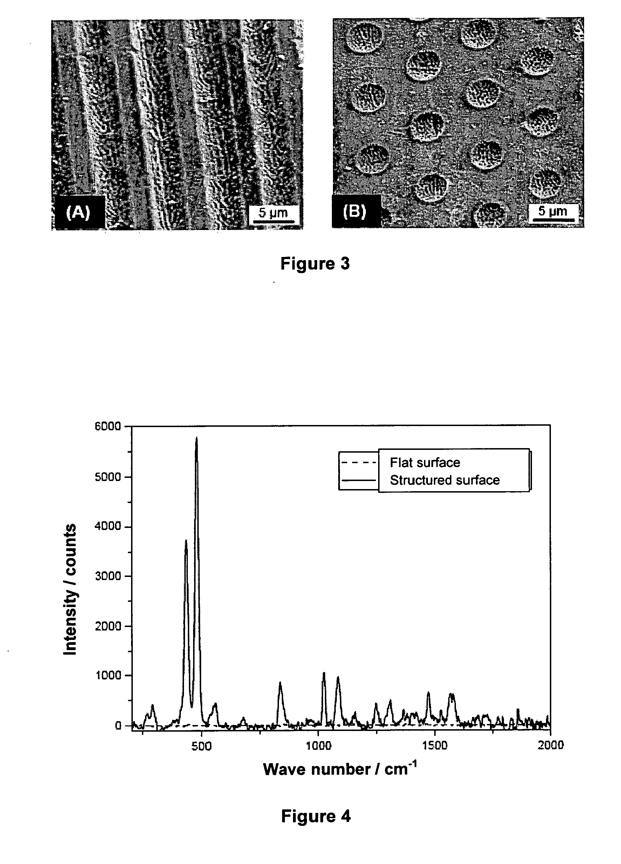

Its implementation requires the surface structure to be covered by a layer of SERS active metals (Ag, Au, Cu, Pt, Pd, etc.) that is thin enough to not completely fill the surface structures. Conventional methods can be used to deposit this layer: deposit by evaporation, deposit by sputtering, deposit of metal nanoparticles from dispersion or electroless electrochemical deposit. Figure 3 shows two SEM photographs of polymers structured with two beams (Figure 3A) and three beams (Fig. 3B) with deposit of metal by evaporation.

The molecule under study is deposited on metal surfaces by: physical adsorption, chemical adsorption, self-assembly, evaporation of solutions, etc.

The SERS spectrum is measured by a monochromatic light impact on the structured surface and by the deposited molecule. The size of the light incidence area can be of the order of square centimeters to square micrometers (Raman microscopy).

<u>Example applied to the detection of p-tioanilina adsorbed on Au</u>

The structure of the surface consists of a polyimide film which is structured by irradiation with the image of a high-power laser interference pattern. The laser is an Nd-YAG laser with 266 or 355 nm wavelengths, 10 ns pulse and 10 Hz pulse frequency. The configuration used for 2 and 3 beams is described in Figures 1 and 2. The fluence is 3 J/cm$^2$. A single pulse is used to form the structures.

Figure 3 shows the resulting images, after the deposit of metal by evaporation.

The deposit of the metal film which consists in a 200nm gold film is carried out by Physical Vapor Deposition (PVD) in ultra high vacuum.

In order to achieve the adsorption of the analyte, a metalized polymeric film is introduced into a solution of analyte (2 mM p-tioanilina in ethanol) and allowed to be adsorbed for 1 hour. It is then washed and dried with nitrogen flow.

In order to obtain the Raman spectrum, the equipment used in this example is a Raman spectrometer with backscattering configuration used to collect the Raman signal through an upright microscope with a long distance objective. This system has high detection sensitivity, using a holographic notch filter to eliminate the Rayleigh scattering of light collection, and two diffraction holographic gratings of 1800 and 600 lines/mm$^{-1}$. The sizes of the slit and pinhole used were 300mm and 500mm respectively. The excitation line was provided by a 632.8nm He-Ne laser with a potency varying from 0.12 mW to 1.2 mW (staying in the lowest values to avoid degrading the sample). The beam size is between 1 and 2 microns.

Figure 4 shows that the intensity of the Raman spectrum signal is about 3 orders of magnitude higher when using the structured surface. Similar results were observed in related spectroscopies such as infrared or fluorescence.

**Claims**

1. Manufacturing method of metal structures, active in surface enhanced Raman spectroscopy or related spectroscopies, implemented in a system comprising at least one lens, a plurality of mirrors and at least one beam splitter; and where the manufacturing method is characterized for comprising, at least, the following steps:

   (i) a first step consisting in splitting a laser beam into sub-beams by using a plurality of mirrors, these sub-beams having an impact on the sample of solid material to ablate or producing a structure;
   (ii) a second step consisting in the deposit of a layer of SERS active metal on the surface structure of the previous step;

(iii) a third step of placing the analyte distributed on the surface of solid material coated with active metal; and

(iv) a fourth step of obtaining the Raman spectrum by a monochromatic light incidence on the molecules immobilized on the surface structure.

2. Method according to claim 1 in which the solid material used is a polymer sensitive to the laser light used.

3. Method according to claim 1 in which the solid material comprises a plurality of copolymers consisting of units sensitive and not sensitive to the laser light used.

4. Method according to claim 1 in which the solid material is a polymeric material doped with substances that increase the absorption of light.

5. Method according to the previous claims in which the laser wavelength is the wavelength at which the material to structure is light sensitive.

6. Use of the methods of claims 1 through 5 to form structures of different geometric shapes on the nanometer or micrometer scale.

7. Metal structure formed according to the methods of claims 1 through 5, **characterized in that** its shapes are determined by the number of laser beams used and the energy of each of these incident beams.

8. Metal structure according to claim 7 wherein the periods and sizes of said structures are of varying dimensions with repetitive periodic distance of up to half the wavelength used and sizes of structures smaller than the wavelength used.

**Figure 1**

**Figure 2**

**Figure 3**

**Figure 4**

**EP 2 343 533 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6623977 B
- US 640677 A
- US 6149868 A
- US 6989897 B
- US 7158219 B
- WO 2009035479 A
- WO 2006027581 A